# EUROPEAN PATENT APPLICATION

(11) **EP 2 293 341 A2**
(43) Date of publication of application: **09.03.2011**
(21) Application number: 10009192.5
(22) Date of filing: 03.09.2010
(51) Int. Cl.: H01L 31/028, H01L 31/0376, H01L 31/065

(54) **Solar cell**

(30) Priority: 04.09.2009 KR 20090083567
(71) Applicant: LG ELECTRONICS INC., Yeongdeungpo-gu Seoul 150-721 (KR)
(72) Inventor: Ji, Kwangsun, Seocho-Gu Seoul 137-724 (KR); Lee, Heonmin, Seocho-Gu Seoul 137-724 (KR); Choi, Wonseok, Seocho-Gu Seoul 137-724 (KR); Choi, Junghoon, Seocho-Gu Seoul 137-724 (KR); Yang, Hyunjin, Seocho-Gu Seoul 137-724 (KR)
(74) Representative: Katérle, Axel

(57) **Abstract**

A solar cell is disclosed. The solar cell includes a substrate containing first impurities of a first conductive type, an emitter layer containing second impurities of a second conductive type opposite the first conductive type, a first electrode electrically connected to the emitter layer, and a second electrode electrically connected to the substrate. The emitter layer and the substrate form a p-n junction. A doping concentration of the second impurities of the emitter layer linearly or nonlinearly changes depending on a depth of a position within the emitter layer.

## Description

### BACKGROUND OF THE INVENTION

### Field of the Invention

The described various implementations relate to a solar cell.

### Description of the Related Art

Recently, as existing energy sources such as petroleum and coal are expected to be depleted, interest in alternative energy sources for replacing the existing energy sources is increasing. Among the alternative energy sources, solar cells for generating electric energy from solar energy have been particularly spotlighted.

A solar cell generally includes a substrate and an emitter layer, each of which is formed of a semiconductor, and electrodes respectively formed on the substrate and the emitter layer. The semiconductors forming the substrate and the emitter layer have different conductive types, such as a p-type and an n-type. A p-n junction is formed at an interface between the substrate and the emitter layer.

When light is incident on the solar cell, a plurality of electron-hole pairs are generated in the semiconductors. The electron-hole pairs are separated into electrons and holes by the photovoltaic effect. Thus, the separated electrons move to the n-type semiconductor (e.g., the emitter layer) and the separated holes move to the p-type semiconductor (e.g., the substrate), and then the electrons and holes are collected by the electrodes electrically connected to the emitter layer and the substrate, respectively. The electrodes are connected to each other using electric wires to thereby obtain electric power.

### SUMMARY OF THE INVENTION

In one aspect, there is a solar cell including a crystalline substrate containing first impurities of a first conductive type. The solar cell also includes a first non-crystalline layer containing second impurities of a second conductive type , the first non-crystalline layer having a first portion that includes a first concentration of the second impurities and a second portion that includes a second concentration of the second impurities, the second portion having a minimum distance from the crystalline substrate that is greater than a minimum distance of the first portion from the crystalline substrate, the second concentration being greater than the first concentration. The solar cell also includes a first electrode and a second electrode electrically connected to the first non-crystalline layer and electrically isolated from the first electrode.

The solar cell may include a second non-crystalline layer containing third impurities of a third conductive type, the second non-crystalline layer having a first portion that includes a first concentration of the third impurities and a second portion that includes a second concentration of the third impurities, the second portion having a minimum distance from the crystalline substrate that is greater than a minimum distance of the first portion from the crystalline substrate, the second concentration being greater than the first concentration, wherein the third conductive type is opposite of the second conductive type. The second non-crystalline layer may be positioned on a non-incident surface of the crystalline substrate upon which light is not incident.

In the solar cell, the first non-crystalline layer may be positioned on an incident surface of the crystalline substrate upon which light is incident. The first non-crystalline layer may be positioned on the non-incident surface of the crystalline substrate upon which light is not incident. The first conductive type may be the same as the third conductive type. The first concentration of the second impurities of the first portion of the first non-crystalline layer may be approximately zero. A concentration of the second impurities may increase at a predetermined rate between the first portion and the second portion.

In the solar cell, the first portion of the first non-crystalline layer may be an intrinsic semiconductor portion, and the second portion of the first non-crystalline layer may be an extrinsic semiconductor portion. The first portion of the first non-crystalline layer may be positioned proximate the crystalline substrate, and the second portion of the non-crystalline layer may be positioned proximate a surface of the non-crystalline layer opposite the crystalline substrate. The first concentration and the second concentration of the second impurities may be from approximately 0 cm⁻³ to approximately 1×10²³ cm⁻³.

In another general aspect, there is a semiconductor structure positioned over a first surface of a crystalline semiconductor substrate of a solar cell, the crystalline semiconductor substrate being a first conductive type. The semiconductor layer may include a first non-crystalline layer having a first concentration of impurities, and a second non-crystalline layer having a second concentration of impurities, the second concentration being different than the first concentration. The first non-crystalline layer and the second non-crystalline layer may each be non-intrinsic layers.

In the semiconductor structure, the first non-crystalline layer may have a minimum distance from the crystalline substrate that is greater than a minimum distance of the second non-crystalline layer from the crystalline substrate. The first concentration of impurities may be greater than the second concentration of impurities. The second concentration of impurities may be greater than the first concentration of impurities.

### BRIEF DESCRIPTION OF THE DRAWINGS

FIG. 1 is a partial cross-sectional view of a solar cell.

FIG. 2 is a graph illustrating an example relationship between an impurity doping concentration and a depth of an emitter layer or a back surface field layer.

FIG. 3 illustrates an energy band diagram between a substrate, an emitter layer, and a back surface field layer.

FIG. 4 is a graph indicating a relationship between a current density and an impurity doping concentration of an emitter layer or a back surface field layer.

FIG. 5 is a graph indicating another example relationship between an impurity doping concentration and a depth of an emitter layer or a back surface field layer.

FIG. 6 is another partial cross-sectional view of a solar cell.

FIG. 7 is a graph indicating an example relationship between an impurity doping concentration and a depth of an emitter layer or a back surface field layer in a solar cell.

FIG. 8 illustrates another energy band diagram between a substrate, an emitter layer, and a back surface field layer in a solar cell.

FIG. 9 shows various example of an emitter layer and a back surface filed layer.

### DETAILED DESCRIPTION OF THE EMBODIMENTS

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

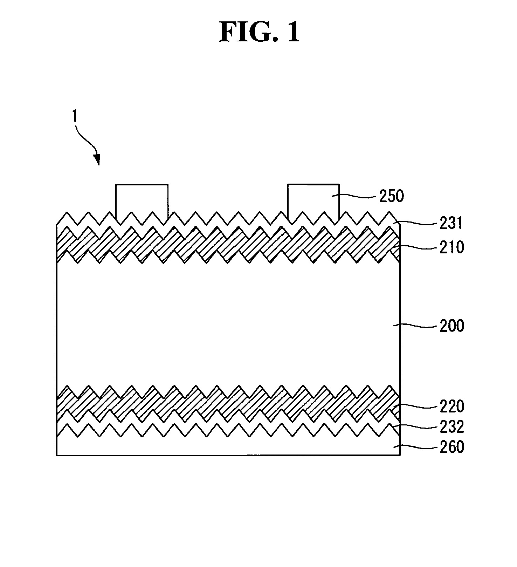

As shown in FIG. 1, a solar cell 1 includes a substrate 200, an emitter layer 210 positioned on a front surface of the substrate 200 on which light is incident, and a back surface field (BSF) layer 220 positioned on a back surface of the substrate 200 opposite the front surface of the substrate 200 on which light is not incident. The solar cell 1 also includes first and second transparent conductive layers 231 and 232 respectively positioned on the emitter layer 210 and the back surface field layer 220, a plurality of front electrodes 250 positioned on the first transparent conductive layer 231, and a back electrode 260 positioned on the second transparent conductive layer 232.

The substrate 200 is a semiconductor substrate formed of first conductive type silicon, such as n-type silicon, or another type of silicon. Silicon in the substrate 200 may be crystalline silicon, such as single crystal silicon and polycrystalline silicon. When the substrate 200 is of an n-type silicon, the substrate 200 may contain impurities of a group V element such as phosphor (P), arsenic (As), and/or antimony (Sb). Alternatively, the substrate 200 may be of a p-type, and/or include materials other than silicon. When the substrate 200 is of the p-type, the substrate 200 may contain impurities of a group III element such as boron (B), gallium (Ga), and/or indium (In).

The entire front and back surfaces of the substrate 200 may be textured to form an uneven surface or a surface having uneven characteristics.

The emitter layer 210 positioned in the front surface of the substrate 200 is an impurity region of a second conductive type (for example, a p-type) opposite the first conductive type (for example, the n-type) of the substrate 200. The emitter layer 210 is formed of a different semiconductor from the substrate 200, for example, a non-crystalline semiconductor, such as amorphous silicon (a-Si). In one example, the emitter layer 210 has a thickness of approximately 10 nm to 50 nm. However, other thicknesses may be used. Thus, the emitter layer 210 and the substrate 200 form not only a p-n junction but also a heterojunction between amorphous and crystalline silicon portions of the solar cell 1.

The back surface field layer 220 on the back surface of the substrate 200 is an impurity region that is more heavily doped with impurities of the same conductive type as the substrate 200. The back surface field layer 220 is formed of a different semiconductor from the substrate 200, for example, a non-crystalline semiconductor, such as amorphous silicon, and thus forms the heterojunction along with the substrate 200.

Accordingly, a movement of holes to the back surface of the substrate 200 is substantially prevented or is reduced by a potential barrier resulting from a difference between impurity doping concentrations of the substrate 200 and the back surface field layer 220. Thus, a recombination and/or a disappearance of electrons and holes around the surface of the substrate 200 is/are substantially prevented or reduced.

In some implementations, each of the emitter layer 210 and the back surface field layer 220 is formed of amorphous silicon and the substrate 200 is formed of crystalline silicon (such as, microcrystalline silicon). Because the crystal structure of the emitter layer 210 and the back surface field layer 220 differ from the crystal structure of the substrate 200, the emitter layer 210 and the back surface field layer 220 each forms a heterojunction with the substrate 200.

As shown in FIG. 1, each of the emitter layer 210 and the back surface field layer 220 may be formed as a single film formed of amorphous silicon.

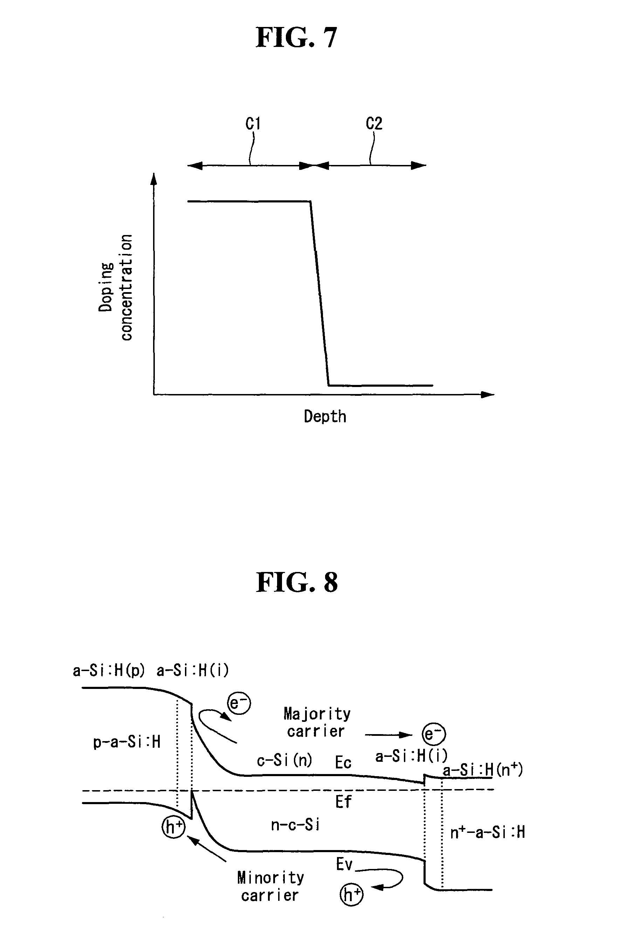

In a case of a comparative example of a solar cell generally having a separate passivation layer formed of, for example, intrinsic amorphous silicon between the substrate and the emitter layer and/or between the substrate and the back surface field layer, as reflected in the relationship between an impurity doping concentration and layer depth shown in FIG. 7, an impurity doping concentration sharply changes around a boundary between the substrate and the emitter layer and/or between the substrate and the back surface field layer.

As shown in FIG. 7, the impurity doping concentration C1 included in the emitter layer or the back surface field layer is relatively high, and an impurity doping concentration C2 of a passivation layer is relatively low. Further, the impurity doping concentration C1 of the emitter layer or the back surface field layer is kept at a generally constant level. In the comparative example, the passivation layer formed of amorphous silicon does not have enough thickness to stably perform a passivation operation that converts unstable bonds, such as a dangling bond, existing around the surface of the substrate into stable bonds to thereby prevent or reduce a recombination and/or a disappearance of carriers moving to each of a front surface and a back surface of the substrate resulting from the unstable bonds. Thus, the passivation layer performs the passivation operation along with the emitter layer or the back surface field layer on the passivation layer.

In other implementations, an impurity doping concentration of each of the emitter layer 210 and the back surface field layer 220 linearly or nonlinearly changes depending on a depth from a surface of the emitter layer 210 and the back surface field layer 220. In other words, as a distance from the surface of each of the emitter layer 210 and the back surface field layer 220 increases towards the surface of the substrate 200, the impurity doping concentration of each of the emitter layer 210 and the back surface field layer 220 changes.

For example, as the distance from the surface increases, the impurity doping concentration of the emitter layer 210 gradually decreases at a predetermined rate. Thus, the impurity doping concentration of the emitter layer 210 around the contact surface between the substrate 200 and the emitter layer 210 is lower than the impurity doping concentration of the emitter layer 210 around the upper surface of the emitter layer 210. As a result, the emitter layer 210 has a relative minimum impurity doping concentration at or near the contact surface between the substrate 200 and the emitter layer 210 and has a relative maximum impurity doping concentration at or near the upper surface of the emitter layer 210.

Further, similar to the emitter layer 210, the impurity doping concentration of the back surface field layer 220 gradually increases at a predetermined rate as a function of distance from the substrate 200. Thus, the impurity doping concentration of the back surface field layer 220 at or near the contact surface between the substrate 200 and the back surface field layer 220 is lower than the impurity doping concentration of the back surface field layer 220 at or near the upper surface of the back surface field layer 220. As a result, the back surface field layer 220 has a relative minimum impurity doping concentration around the contact surface between the substrate 200 and the back surface field layer 220 and may have a relative maximum impurity doping concentration around the upper surface of the back surface field layer 220.

In other examples, as the emitter layer 210 and the back surface field layer 220 extend from the contact surfaces between the emitter layer 210 and the back surface field layer 220 and substrate 200, the impurity doping concentration of each of the emitter layer 210 and the back surface field layer 220 may gradually decrease. In these examples, the emitter layer 210 and the back surface field layer 220 may have a relative maximum impurity doping concentration at or near the contact surfaces between the substrate 200, and may have a relative minimum impurity doping concentration at or near the upper surfaces of the emitter layer 210 and the back surface field layer 220. Additionally, a relationship between the impurity doping concentration of the emitter layer 210 and a distance from the upper surface of the emitter layer 210 may be different than a relationship between the impurity doping concentration of the back surface field layer 220 and a distance from the upper surface of the back surface field layer 220. For example, the relationship between the impurity doping concentration of the emitter layer 210 and the distance from the upper surface of the emitter layer 210 may be the opposite of the relationship between the impurity doping concentration of the back surface field layer 220 and the distance from the upper surface of the back surface field layer 220.

In some implementations, the impurity doping concentration of each of the emitter layer 210 and the back surface field layer 220 at or near the substrate 200 may be at least 0 cm⁻³, and the impurity doping concentration of each of the emitter layer 210 and the back surface field layer 220 at or near the upper surfaces of the emitter layer 210 and the back surface field layer 220 may be at most approximately 1×10²³ cm⁻³.

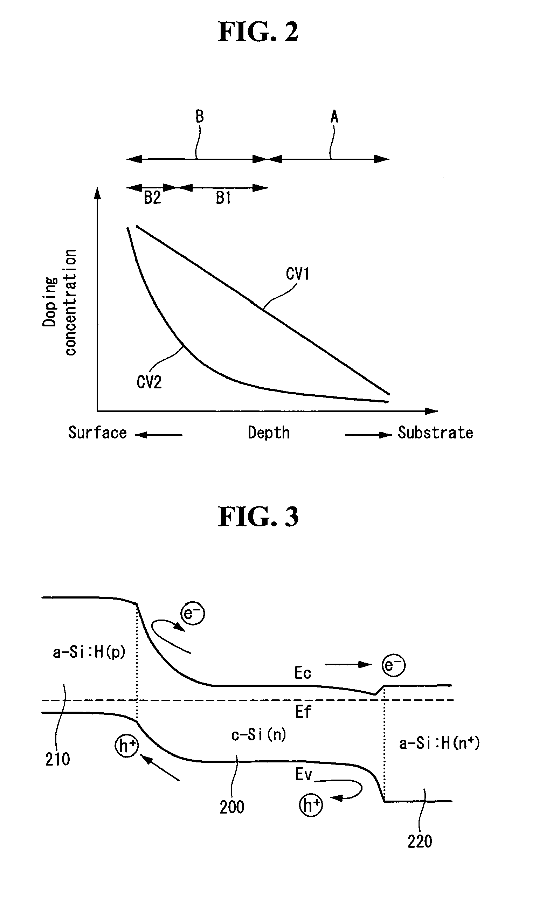

With regard to the production of the solar cell 1, after an initial stage of the formation of the emitter layer 210 and/or the back surface field layer 220 is started, an amount of dopant gas present in the atmosphere of a process chamber is gradually increased from a state of substantially no dopant gas as the formation of the emitter layer 210 and/or the back surface field layer 220 progresses. Hence, the emitter layer 210 and/or the back surface field layer 220 each formed having a gradually changing impurity doping concentration. As shown in FIG. 2, the impurity doping concentration inside the emitter layer 210 and/or the back surface field layer 220 is indicated by a linear graph CV1 indicating a linear change or a curvilinear graph CV2 indicating a nonlinear change.

FIG. 2 is a graph illustrating a reduction in the impurity doping concentration of the emitter layer 210 and/or the back surface field layer 220 as a position within the emitter layer 210 and/or the back surface field layer 220 is close to the substrate 200 and an increase in the impurity doping concentration of the emitter layer 210 and/or the back surface field layer 220 as a position within the emitter layer 210 and/or the back surface field layer 220 is close to the upper surface of the emitter layer 210 and/or the back surface field layer 220.

As above, the solar cell 1 shown in FIG. 1 does not require a separate passivation layer capable of performing a passivation operation that converts unstable bonds, such as dangling bonds, existing between the substrate 200 and the emitter layer 210, between the substrate 200 and the back surface field layer 220, and around the surface of the substrate 200 into stable bonds to thereby prevent or reduce a recombination and/or a disappearance of carriers moving to each of the front surface and the back surface of the substrate resulting from the unstable bonds.

In some implementations, when the emitter layer 210 and/or the back surface field layer 220 have an impurity doping concentration that generally decreases as distance from the surface (for example, the upper surface) of the emitter layer 210 and/or the back surface field layer 220 increases, the upper surface of the emitter layer 210 and/or the back surface field layer 220 exhibits an extrinsic semiconductor characteristic, and a portion of the emitter layer 210 and/or the back surface field layer 220 at or near the substrate 200 exhibits an intrinsic semiconductor characteristic. On the contrary, when the emitter layer 210 and/or the back surface field layer 220 has an impurity doping concentration that increases with distance from the upper surface of the emitter layer 210 and/or the back surface field layer 220, the upper surface of the emitter layer 210 and/or the back surface field layer 220 exhibits an intrinsic semiconductor characteristic, and a portion of the emitter layer 210 and/or the back surface field layer 220 at or near the substrate 200 exhibits an extrinsic semiconductor characteristic.

Although each of the emitter layer 210 and the back surface field layer 220 illustrated in FIG. 1 has a single-layered structure, each of the emitter layer 210 and the back surface field layer 220 may perform the passivation operation as well as the above-described operations. More specifically, an intrinsic semiconductor portion of the emitter layer 210 and/or the back surface field layer 220 having a low impurity doping concentration converts unstable bonds existing around the surface of the substrate 200 into stable bonds to thereby prevent a loss of carriers and also reduces a damage (for example, a loss of carriers) resulting from a combination between impurities and carriers because of its low impurity doping concentration. Additionally, an extrinsic semiconductor portion of the emitter layer 210 and/or the back surface field layer 220 having a high impurity doping concentration forms the p-n junction with the substrate 200 or form the potential barrier along with the substrate 200 to thereby perform operations of the emitter layer 210 and/or the back surface field layer 220.

With regard to the solar cell 1 of FIG. 1, the intrinsic semiconductor portion has thickness sufficient to stably perform the passivation operation. In some implementations, the intrinsic semiconductor portion has a thickness of for example, at least 6 nm. As mentioned above, and as shown in FIG. 2, a slope of the graph indicating the impurity doping concentration may increase as the emitter layer 210 and/or the back surface field layer 220 extends from the intrinsic semiconductor portion at or near the substrate 200 to the extrinsic semiconductor portion at or near the upper surface. In other words, the impurity doping concentration within the emitter layer 210 and/or the back surface field layer 220 increases to a concentration level capable of performing the passivation operation after transitioning from the substrate 200, and then increases further, and to a greater degree, before transitioning to the first and second transparent conductive layers 231 and 232. Hence, the conductivity and the contact characteristic of the solar cell 1 are improved.

In FIG. 2, the portion "A" indicates an intrinsic semiconductor portion where the intrinsic semiconductor characteristic is exhibited and the passivation operation is performed, and the portion "B" indicates an extrinsic semiconductor portion where the extrinsic semiconductor characteristic is exhibited and the emitter operation or the back surface field operation is performed.

The extrinsic semiconductor portion B includes a portion B1 where an emitter operation and/or a back surface field operation is performed and a contact portion B2. An impurity doping concentration of the contact portion B2 is higher than an impurity doping concentration of the portion B1, and a thickness of the portion B2 is less than a thickness of the intrinsic semiconductor portion A associated with the passivation operation.

Accordingly, because the a separate passivation layer (for example, an amorphous silicon layer such as an intrinsic amorphous silicon layer) is not necessary if the emitter layer 210 and/or the back surface field layer 220 include the intrinsic semiconductor portion A, a separate chamber forming the passivation layer is not necessary. The manufacturing cost and time of the solar cell 1 are reduced by formation of the emitter layer 210 and/or the back surface field layer 220 including the intrinsic semiconductor portion A. Further, because detrimental changes in characteristics of the substrate 200 or other layers generated in a formation process of the passivation layer are substantially prevented, the efficiency of the solar cell 1 is improved by formation of the emitter layer 210 and/or the back surface field layer 220 including the intrinsic semiconductor portion A. Additionally, because the passivation operation is performed in the emitter layer 210 and/or the back surface field layer 220 at or near the substrate 200 without a separate passivation layer, an open-circuit voltage of the solar cell 1 is improved and the efficiency of the solar cell 1 is improved.

In some implementations, the first and second transparent conductive layers 231 and 232 are respectively positioned on the entire surface of the emitter layer 210 and the entire surface of the back surface field layer 220 and are formed of transparent conductive oxide (TCO) such as indium tin oxide (ITO) and aluminum-doped zinc oxide (AZO). In some implementations, the second transparent conductive layer 232 on the back surface of the substrate 200 on which light is not incident may be formed of an opaque or translucent conductive material. In this case, light passing through the substrate 200 is reflected by the second transparent conductive layer 232 and then is again incident on the substrate 200. Hence, the efficiency of the solar cell 1 can be improved by selecting an opaque or translucent conductive material for the second conductive layer 232.

The first and second transparent conductive layers 231 and 232 each have good conductivity. Thus, light incident on the front surface of the substrate 200 is incident inside the substrate 200 through the first transparent conductive layer 231. Moreover, carriers (e.g., holes) moving to the emitter layer 210 are transferred to the front electrodes 250 through the first transparent conductive layer 231 and carriers (e.g., electrons) moving to the back surface field layer 220 are transferred to the back electrode 260 through the second transparent conductive layer 232.

The front electrodes 250 on the first transparent conductive layer 231 extend substantially parallel to one another in a fixed direction and are electrically connected to the emitter layer 210 through the first transparent conductive layer 231. Thus, the front electrodes 250 collect the carriers (e.g., holes) moving to the emitter layer 210.

The solar cell 1 shown in FIG. 1 may further include a plurality of front electrode current collectors (not shown) that extend substantially parallel to one another in a direction crossing an extending direction of the front electrodes 250. The plurality of front electrode current collectors are positioned on the same level layer as the front electrodes 250 and are electrically and physically connected to the front electrodes 250 at each of crossings of the front electrode current collectors and the front electrodes 250. Thus, the front electrodes 250 and the front electrode current collectors are positioned on the front surface of the substrate 200 in a lattice shape. The front electrode current collectors collect carriers moving to the front electrodes 250. The front electrode current collectors may be attached to a conductive tape connected to an external device and may output the collected carriers to the external device through the conductive tape. In some implementations, other configurations of the front electrodes 250 and/or the front electrode current collectors can be used or included.

The back electrode 260 is positioned on substantially the entire surface of the second transparent conductive layer 232 and is electrically connected to the back surface field layer 220 through the second transparent conductive layer 232. Thus, the back electrode 260 collects carriers (e.g., electrons) moving to the back surface field layer 220.

Further, the solar cell 1 may include a plurality of back electrode current collectors on the back electrode 260 or the second transparent conductive layer 232. The back electrode current collectors are positioned opposite the front electrode current collectors with the substrate 200 interposed therebetween. Similar to the front electrode current collectors, the back electrode current collectors may collect carriers moving to the back electrode 260, may be attached to a conductive tape connected to an external device, and may output the collected carriers to the external device through the conductive tape.

The front electrodes 250 and the back electrode 260 may be formed of at least one conductive material selected from the group consisting of nickel (Ni), copper (Cu), silver (Ag), aluminum (Al), tin (Sn), zinc (Zn), indium (In), titanium (Ti), gold (Au), alloys of these, and combinations thereof. However, other conductive materials may be used.

The front electrode current collectors and the back electrode current collectors transferring carriers to the external device may contain a conductive material. Conductivity of the conductive material used in the front electrode current collectors and the back electrode current collectors may be better than conductivity of the electrodes 250 and 260, if necessary or desirable.

The front electrodes 250 and the back electrode 260 (in addition, the front electrode current collectors and the back electrode current collectors) may be formed having desired patterns on the first and second transparent conductive layers 231 and 232 using a photomask or a screen printing method and then performing a thermal process on the patterns. In this case, the back electrode current collectors may be formed on the back electrode 260.

In use, when light irradiated to the solar cell 1 is incident on the substrate 200 through the first transparent conductive layer 231, multiple electron-hole pairs are generated in the substrate 200. Loss of light incident on the substrate 200 due to reflection away from the substrate and back through the first transparent conductive layer 231 is reduced due to a texture of a surface of the substrate 200. Moreover, a light absorption increases because the textured surface of the substrate 200 causes incident light to be reflected into the substrate 200. Hence, the efficiency of the solar cell 1 is improved.

The electron-hole pairs are separated into electrons and holes by the p-n junction of the substrate 200 and the emitter layer 210. The separated holes move to the p-type emitter 210 and then are collected by the front electrodes 250. The separated electrons move to the n-type back surface field layer 220 and are collected by the back electrode 260. When the front electrodes 250 are connected to the back electrode 260 using electric wires (not shown), current flows therein to thereby enable use of the current for electric power.

As mentioned previously with regard to FIG. 1, a separate (intrinsic) amorphous silicon layer (i.e., the passivation layer) is not formed between the substrate 200 and the emitter layer 210 or between the substrate 200 and the back surface field layer 220. Therefore, as shown in FIG. 3, energy band gap differences around an interface between the substrate 200 and the emitter layer 210 and around an interface between the substrate 200 and the back surface field layer 220 are reduced. Hence, the energy band gap gently changes in the interface between the substrate 200 and the emitter layer 210 and the interface between the substrate 200 and the back surface field layer 220.

In the case of the comparative example of forming the separate passivation layer (for example, an intrinsic amorphous silicon layer) between the substrate and the emitter layer and/or between the substrate and the back surface field layer, an energy band diagram illustrated in FIG. 8 is obtained. As shown in FIG. 8, the substrate is n-type crystalline silicon indicated by n-c-Si(n), the emitter layer is p-type amorphous silicon indicated by a-Si:H(p), the back surface field layer is n-type amorphous silicon indicated by a-Si:H(n⁺), and the passivation layer is intrinsic amorphous silicon indicated by a-Si:H(i). Because a relatively large band offset (i.e., a difference between energy band gaps of the substrate and the passivation layer) is generated by including the separate passivation layer, smooth connections between energy band gaps of the layers are not achieved.

In other words, there are relatively large energy band gap differences between the substrate and the emitter layer and between the substrate and the back surface field layer when the separate passivation layer is included. The energy band gap difference adversely affects the movement of electrons "e⁻" (corresponding to majority carriers) moving to the back surface field layer and the movement of holes "h⁺" (corresponding to minority carriers) moving to the emitter layer.

In addition, when the separate passivation layer is formed having a relatively large thickness, the thick passivation layer disturbs or impedes a tunneling effect of carriers and disturbs or impedes the movement of carriers. Particularly, movement of the carriers is disturbed or impeded as they pass through the passivation layer due to poor conductivity of the amorphous silicon. Hence, the inclusion of a separate passivation layer reduces the efficiency of the solar cell. Additionally, the thickness of the separate passivation layer cannot be reduced due to a reduced affect on the ability of the separate passivation layer to perform a passivation function associated with reduced thickness.

With regard to FIG. 3, because a separate passivation layer is not included between the substrate 200 and the emitter layer 210, or between the substrate 200 and the back surface field layer 220, the energy band gap differences between the substrate 200 and the emitter layer 210 and between the substrate 200 and the back surface field layer 220 are smaller compared to the energy bad gap differences associated with the separate passivation layer. Accordingly, as described above, the energy band gap changes gradually or smoothly across the interface between the substrate 200 and the emitter layer 210 and across the interface between the substrate 200 and the back surface field layer 220. Thus, carriers h⁺ and e⁻ easily move to the emitter layer 210 and the back surface field layer 220.

Further, because a distance between the substrate 200 and the emitter layer 210 and a distance between the substrate 200 and the back surface field layer 220 is reduced when a separate passivation layer is not included, carriers may easily move and an amount of loss of carriers during the movement of carriers may be reduced.

As above, when passivation is achieved by varying the impurity doping concentrations of the emitter layer 210 and the back surface field layer 220, each of which is formed of amorphous silicon, the thickness of the solar cell 1 may be reduced compared to solar cells that include one or more separate passivation layers. Further, carriers may easily move because the contact surface between the substrate 200 and the emitter layer 210 and the contact surface between the substrate 200 and the back surface field layer 220 have the impurity doping concentrations that are suitable for carrier conduction.

In other words, with regard to the carrier movement, implementations where the portions of the emitter layer 210 and the back surface field layer 220 performing the passivation operation contain relatively small concentrations of impurities may be more advantageous than implementations where the portions of the emitter layer 210 and the back surface field layer 220 performing the passivation operation do not contain any impurities. Further, a current density of the solar cell 1 is improved by the inclusion of the relatively small concentrations of impurities in the portions performing the passivation operation.

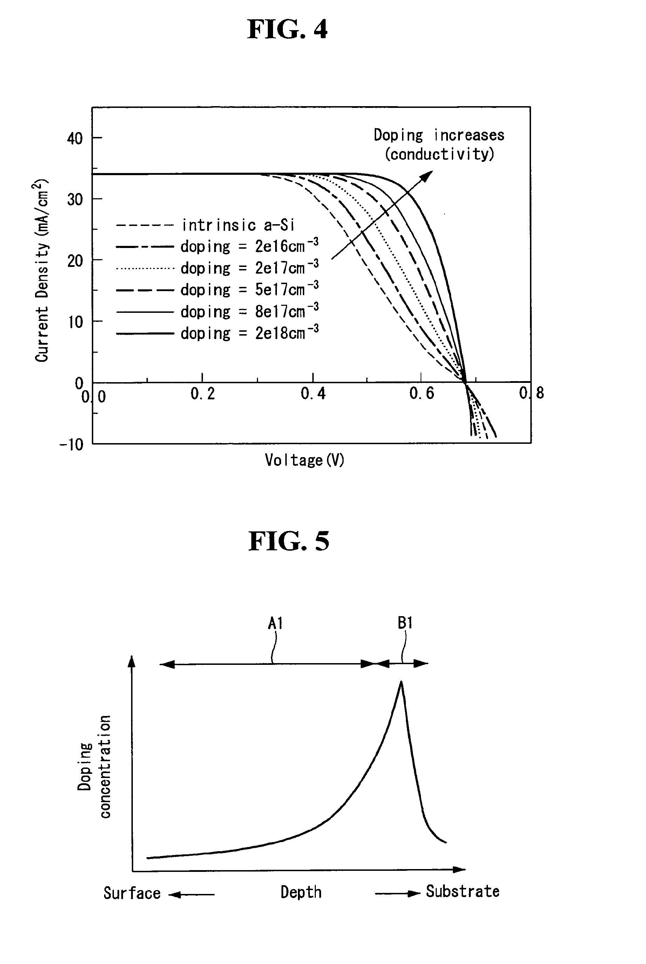

FIG. 4 illustrates changes in a current density and a voltage depending on an impurity doping concentration of an amorphous silicon layer including 6 graphs. As shown in FIG. 4, an intrinsic a-Si layer scarcely containing impurities has a minimum current density and a minimum voltage, and an a-Si layer having a maximum impurity doping concentration has a maximum current density and a maximum voltage. As above, as the impurity doping concentration increases, a magnitude of the voltage increases. Hence, a magnitude of an output power (i.e., P=V×I) increases.

However, in the comparative example, because only the intrinsic a-Si passivation layer performs the passivation operation, the passivation layer performs the passivation operation along with the emitter layer or the back surface field layer positioned on the passivation layer. Thus, when the impurity doping concentration of the emitter layer or the back surface field layer increases, the passivation effect decreases. Hence, a magnitude of an output voltage and a magnitude of an output power decrease.

However, with regard to solar cell 1, because the passivation operation may be performed using only the intrinsic semiconductor portions of the emitter layer 210 and the back surface field layer 220, the passivation effect does not decrease even if impurity doping concentrations of other portions of each of the emitter layer 210 and the back surface field layer 220 increase. As shown in FIG. 4, the magnitude of the output power may increase through an increase in the impurity doping concentration.

The impurity doping concentration of the a-Si layer used as the emitter layer 210 or the back surface field layer 220 gradually increases from 0 (in case of the intrinsic a-Si layer) to or through, 2×10¹⁶ cm⁻³, 2×10¹⁷ cm⁻³, 5×10¹⁷ cm⁻³, 8×10¹⁷ cm⁻³, and 2×10¹⁸ cm⁻³ as the a-Si emitter layer or the a-Si back surface field layer 220 is formed on the substrate 200. Other amounts of the impurity doping concentration may be used. For example, the impurity doping concentration may linearly or nonlinearly change within an impurity doping concentration range of 0 cm⁻³ to 1×10²³ cm⁻³.

Further, as shown in FIG. 5, the graph indicates that the impurity doping concentration of the emitter layer 210 and the back surface field layer 220 may linearly or nonlinearly increase within the range of 0 cm⁻³ to 10×10²³ cm⁻³ as the emitter layer 210 and the back surface field layer 220 are formed on the substrate 200.

FIG. 5 is a graph indicating changes in the impurity doping concentration of the emitter layer and/or the back surface field layer. As shown in FIG. 5, the impurity doping concentration inside the emitter layer 210 and/or the back surface field layer 220 nonlinearly changes similar to the graph of FIG. 2.

As described above, in FIG. 5, an impurity doping concentration of a contact portion B1 between the substrate 200 and the emitter layer 210 and/or between the substrate 200 and the back surface field layer 220 is higher than an impurity doping concentration of the remainder A1 of the emitter layer 210 and/or the back surface field layer 220. The contact portion B1 may include a contact surface between the substrate 200 and the emitter layer 210 and/or between the substrate 200 and the back surface field layer 220. Hence, the impurity doping concentration of the emitter layer 210 and/or the back surface field layer 220 decreases from the contact portion B1 to the upper surface of the emitter layer 210 and/or the back surface field layer 220. The passivation effect is generated in a portion of the emitter layer 210 and/or the back surface field layer 220 that does not contain impurities or that has a low impurity doping concentration. Further, because an impurity doping concentration of the surface of the emitter layer 210 corresponding to a light incident surface is low, a reduction in an incident amount of light resulting from impurities is avoided compared to an implementation where the impurity doping concentration of the surface of the emitter layer 210 is relatively high. Hence, the efficiency of the solar cell 1 is improved by providing a relatively low impurity doping concentration at the surface of the emitter layer 210.

In FIG. 5, graphing a doping concentration at varying positions within the emitter layer 210 and/or the back surface field layer 220, illustrates that the impurity doping concentration of the emitter layer 210 and/or the back surface field layer 220 sharply decreases within the contact portion B1 approaching the substrate 200. Thus, the intrinsic semiconductor characteristic appears in the sharply decreasing portion of the impurity doping concentration. The sharply decreasing portion performs the passivation operation around the interface between the substrate 200 and the emitter layer 210 and/or between the substrate 200 and the back surface field layer 220.

Alternatively, the emitter layer 210 and the back surface field layer 220 may have a linearly changing impurity doping concentration within the contact portion B1 and/or the remainder A1.

Accordingly, as described above, because the passivation effect is generated in the emitter layer 210 and/or the back surface field layer 220 by changing the impurity doping concentration of the emitter layer 210 and/or the back surface field layer 220 without including a separate passivation layer, the open-circuit voltage of the solar cell 1 is improved and the efficiency of the solar cell 1 is improved.

The efficiency of a heterojunction solar cell depending on changes in an impurity doping concentration of an emitter layer is described with reference to the following Table 1, which indicates simulated results of the efficiency of a solar cell depending on changes in an impurity doping concentration of a p-type emitter layer when the p-type emitter layer (for example, an amorphous silicon layer) was formed on an n-type crystalline silicon substrate.

Moreover, Table 1 illustrates result under the assumption that there is no increase in defect formation associated with varying the impurity doping concentrations. More specifically, because only an intrinsic semiconductor portion performs the passivation operation in the same manner as solar cell 1 of FIG. 1, the passivation effect is not adversely affected even if an impurity doping concentration of an extrinsic semiconductor portion increases.

In the following Table 1, an impurity doping concentration of the substrate is approximately 5×10¹⁵ /cm⁻³, and resistivity of the substrate is approximately 0.99850 Ω.cm. As indicated in the following Table 1, as an impurity doping concentration of the emitter layer increases, an open-circuit voltage Voc and a fill factor FF increases. Hence, the efficiency of the emitter layer increases as the impurity doping concentration of the emitter layer increases. Because the conductivity of the emitter layer increases as the impurity doping concentration of the emitter layer increases, a magnitude of activation energy for solving the energy band gap difference greatly decreases.

In solar cell 1 of FIG. 1, because a junction portion serving as the emitter layer and/or the back surface field layer is very thinly formed using a layer with a relatively high impurity doping concentration, a shallow junction is induced. Additionally, because the surface passivation of the silicon substrate requires a minimum thickness of the a-Si layer, the sufficient junction may be formed, and a reduction in the passivation effect resulting from the defect may be minimized. Further, because a heavily doped region is locally formed, a short-circuit current density Jsc was very slightly reduced because of very low light transmission. When the above conditions are applied to the back surface field layer rather than the emitter layer, the back surface field layer may have a minimum thickness capable of maintaining the passivation operation while locally inducing a strong reflection of minority carriers. Hence, a parallel resistance of the solar cell may be reduced.

**[Table 1]**

| | | | | | |
|---|---|---|---|---|---|
| Impurity doping concentration of substrate | 5.00E+15 | 5.00E+15 | 5.00E+15 | 5.00E+15 | 5.00E+15 |
| Resistivity of substrate (Ω.cm) | 0.99850 | 0.99850 | 0.99850 | 0.99850 | 0.99850 |
| Impurity doping concentration of emitter layer (#/cm⁻³) | 1.25E+20 | 5.00E+19 | 2.50E+19 | 1.25E+19 | 5.00E+18 |
| Activation Energy (eV) | 0.28 | 0.36 | 0.43 | 0.46 | 0.48 |
| Voc (V) | 0.645 | 0.638 | 0.631 | 0.621 | 0.615 |
| Jsc (mA/cm²) | 36.320 | 36.300 | 36.410 | 36.580 | 36.710 |
| FF (%) | 76.310 | 76.850 | 76.640 | 72.760 | 63.560 |
| Efficiency (%) | 17.860 | 17.810 | 17.590 | 16.530 | 14.340 |

The emitter layer 210 and/or the back surface field layer 220 can be formed such that the desired distributions of impurities are included. For example, the emitter 210 can be continuously formed in a single process chamber as a single layer. In this example, a concentration of the impurities present in the process chamber are controlled over time such that a portion of the emitter layer 210 formed at a first time includes a first concentration of impurities, and a second portion of the emitter layer 210 formed at a second time, which is different than the first time, includes a second concentration of impurities. As discussed above, as the emitter layer 210 is formed, the concentration of impurities contained in the emitter layer 210 can be controlled to vary linearly or non-linearly, and the concentration can be increased and decreased over time as desired to form the emitter layer 210 with a desired profile of impurity concentration from the substrate 200 to the upper surface of the emitter layer 210. The back surface field layer 220 can be formed by a similar process in a separate process chamber, or both the emitter layer 210 and the back surface field layer 220 can be formed in the single process chamber at different times. In any case, the layers formed according to this example include impurity concentrations within the layers that vary according to varying concentrations of impurities present in the process chamber which are controlled during the formation of the layers.

Additionally, in this example, the impurity concentration within the emitter layer 210 at a given depth from the upper surface and/or at a given distance above the substrate 200 is substantially constant across a length and width of the emitter layer 210. However, the concentration of impurities within the emitter layer 210 (as is also true of the back surface field layer 220) can vary in a controlled manner, or can vary due to random or uncontrolled factors that affect the formation process of the layer.

In another example, a layer, such as the emitter layer 210, can be formed in one or more chambers during two or more separate formation processes. For example, a first portion of the emitter layer can be formed in a first process chamber at a first time and a second portion of the emitter layer 210 can be formed in a second process chamber or the first process chamber at a second time. The concentration of impurities present in the first process chamber (and in the second process chamber if used) can be maintained substantially constant during the formation of each of the first and second portions of the emitter layer 210. However, the concentration present in the first process chamber is different than, such as less than, a concentration present during formation of the second portion. Additionally, or alternatively, the separate first and second portions of the emitter layer 210 can be formed while varying the concentration of the impurities in the process chamber linearly or non-linearly.

In another example, three or more distinct portions of a layer, such as the emitter layer 210 can be formed, either separately or integrally using varying impurity concentrations, constant impurity concentrations, or combinations of both. The distinct portions, if separately formed, can be formed in one or more process chambers. For example, each separate portion can be formed in a separate process chamber, if desired. Similarly, other layers can be added in the same or different process chambers, and/or various treatments or other processes can also be performed before, during, or after formation of the emitter layer 210 and/or the back surface field layer 220.

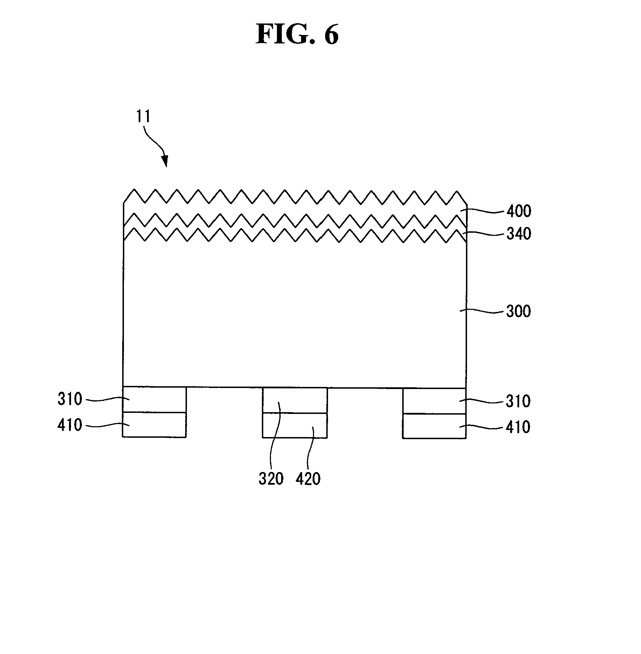

The principles described above with regard to solar cell 1 of FIG. 1 may be applied to not only a heterojunction solar cell but also a back contact solar cell, as illustrated in FIG. 6. Particularly, FIG. 6 is a partial cross-sectional view of another solar cell 11. Unlike the solar cell 1 illustrated in FIG. 1, a plurality of front electrodes (and a plurality of front electrode current collectors) are positioned on a back surface of a substrate 300 on which light is not incident.

More specifically, the solar cell 11 includes the substrate 300, a passivation layer 340 positioned on a front surface of the substrate 300 on which light is incident, an anti-reflection layer 400 positioned on the passivation layer 340, one or more emitter layers 310 positioned on the back surface of the substrate 300, one or more back surface field layers 320 that are positioned on the back surface of the substrate 300 and are separated from the plurality of emitter layers 310, one or more first electrodes 410 respectively positioned on the one or more emitter layers 310, and one or more second electrodes 420 respectively positioned on the one or more back surface field layers 320.

The substrate 300 is substantially the same as the substrate 200 illustrated in FIG. 1, and is formed of first conductive type crystalline silicon (for example, n-type crystalline silicon).

The passivation layer 340 is formed of intrinsic amorphous silicon and performs a passivation operation that converts unstable bonds generally existing around the surface of the substrate 300 into stable bonds, as described above. Because the passivation layer 340 is formed of intrinsic amorphous silicon scarcely containing impurities, a defect such as a loss of carrier resulting from the impurities is prevented or reduced. The passivation layer 340 may be formed of a silicon containing semiconductor such as silicon nitride (SiNx) and amorphous silicon nitride (a-SiNx), a non-conductive layer such as amorphous silicon dioxide (SiO₂), amorphous silicon oxide (a-SiO), and titanium dioxide (TiO₂), non-conductive polymer, or a paste containing these materials, in addition to amorphous silicon.

The anti-reflection layer 400 reduces a reflectance of light incident on the solar cell 11 and increases a selectivity of a predetermined wavelength band, thereby increasing the efficiency of the solar cell 11. The anti-reflection layer 400 may have a proper refractive index so as to increase an anti-reflection effect. The anti-reflection layer 400 may be formed of SiNx, SiO₂, SiNx:H, or SiO₂:H.

As illustrated in FIG. 6, the anti-reflection layer 400 has a single-layer structure. However, the anti-reflection layer 400 may have a multi-layered structure such as a double-layer structure. Alternatively, the anti-reflection layer 400 may be omitted, if desired. The anti-reflection layer 400 performs the passivation operation in the same manner as the passivation layer 340. Hence, an amount of carriers that disappear resulting from the unstable bonds is reduced by the passivation effect of the passivation layer 340 and the anti-reflection layer 400 on the front surface of the substrate 300. As a result, the efficiency of the solar cell 11 is improved.

The one or more emitter layers 310 on the back surface of the substrate 300 are separated from one another and extend substantially parallel to one another in a fixed direction. Because each of the emitter layers 310 is of a conductive type opposite a conductive type of the substrate 300, in the same manner as the emitter layer 210 of FIG. 1, each emitter layer 310 and the substrate 300 form a p-n junction. Each emitter layer 310 is of a p-type and is formed of amorphous silicon in the same manner as the emitter layer 210 of FIG. 1.

The one or more back surface field layers 320 are separated from the emitter layers 310 and extend on the substrate 300 substantially parallel to the emitter layers 310. Each of the back surface field layers 320 is formed of amorphous silicon containing impurities of the same conductive type as the substrate 300 in the same manner as the back surface field layer 220 of FIG. 1.

An impurity doping concentration of each emitter layer 310 and an impurity doping concentration of each back surface field layer 320 linearly or nonlinearly changes in the same manner as the impurity doping concentrations of the emitter layer 210 and the back surface field layer 220 of FIG. 1. In other words, the impurity doping concentration and the characteristics of each emitter layers 310 and each back surface field layers 320 are substantially the same as those of the emitter layer 210 and the back surface field layer 220 of FIG. 1, except for their formation location and a shape. Accordingly, in each emitter layer 310 and each back surface field layer 320, a passivation operation is performed in a portion with a low impurity doping concentration, and an emitter operation and a back surface field operation, respectively, are performed in a portion where an impurity doping concentration is higher than a set concentration.

The first and second electrodes 410 and 420 are formed of a conductive material and overlie the emitter layers 310 and the back surface field layers 320. The first and second electrodes 410 and 420 output carriers moving to and through the emitter layers 310 and the back surface field layers 320 respectively from the substrate 300 to an external device.

As described above, low impurity doping concentration portions of the emitter layers 310 and the back surface field layers 320 perform the passivation operation without a separate passivation layer.

Further, because light is incident on the entire front surface of the substrate 300, an amount of light incident on the substrate 300 increases. Hence, the efficiency of the solar cell 11 is improved. In addition, because the anti-reflection layer 400 reduces a reflection loss of light incident on the substrate 300, an amount of light incident on the substrate 300 is not reduced.

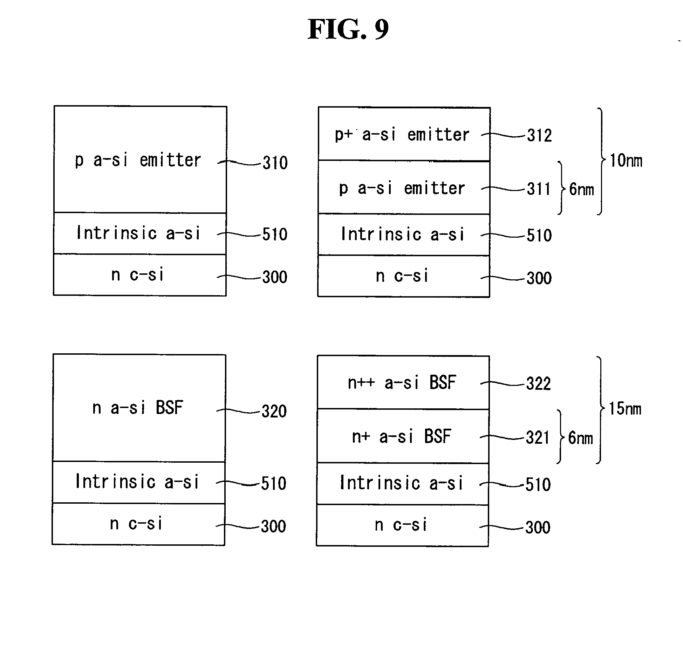

Referring to FIG. 9, various examples of the solar cell according to exemplary embodiment of the present invention will be described.

As shown in FIG. 9, an example of the solar cell further includes a separate intrinsic amorphous silicon layer 510 between the substrate 300 and the emitter layer 310 and/or between the substrate 300 and the back surface field layer 320. The intrinsic amorphous silicon layer 510 is a passivation layer performing the passivation operation. At this time, each impurity doping concentration of the emitter layer 310 and the back surface filed layer 320 is linearly or nonlinearly changed from approximately 0 cm⁻³ to approximately 1×10²³ cm⁻³.

Thereby, since the passivation function is performed by the intrinsic amorphous silicon layer 510 as well as the emitter layer 310 and/or the passivation layer 320, the passivation effect is further improved.

In addition, as shown in FIG. 9, another example of the solar cell also includes a separate intrinsic amorphous silicon layer 510 between the substrate 300 and the emitter layer 310 and/or between the substrate 300 and the back surface field layer 320. As described above, the intrinsic amorphous silicon layer 510 performs the passivation operation. However, as shown in FIG. 9, the solar cell includes a first emitter layer 311 positioned on the intrinsic amorphous silicon layer 510, in which impurities are doped, and a second emitter layer 312 positioned on the first emitter layer 311, and includes a first back surface field layer 321 positioned on the intrinsic amorphous silicon layer 510, in which impurities are doped and a second back surface filed layer 322 positioned on the first back surface field layer 321. At this time, the impurity doping concentrations of the first emitter layer 311 and the first back surface filed layer 321 are less than those of the second emitter layer 312 and the second back surface filed layer 322, respectively.

The first emitter layer 311 mainly functions as the passivation layer, and the second emitter layer 312 function as an emitter layer forming the p-n junction with the substrate 300. However, the first emitter layer 311 also forms the p-n junction along with the second emitter layer 312.

The first back surface field layer 321 mainly functions as the passivation layer and the second back surface filed layer 322 mainly performs the potential barrier. The first back surface field layer 321 also forms the potential barrier.

Thereby, since the passivation function is performed by the intrinsic amorphous silicon layer 510 as well as the first emitter layer 311 and/or the first passivation layer 321, the passivation effect is further improved.

In FIG. 9, a thickness of the emitter layer 310 is substantially 10nm and the a thickness of the back surface field layer 320 is substantially 15nm

When the emitter layer 310 has the thickness of about 10nm, the emitter layer 310 stably performs the p-n junction and further performs the passivation operation. When the back surface filed layer 330 has the thickness of about 5nm, the back surface field layer 320 stably forms the potential barrier and further performs the passivation operation.

Further, the first emitter layer 311 has a thickness of about 6nm and the total thickness of the first and second emitter layers 311 and 312 is substantially 10nm, and the first back surface field layer 321 has a thickness of about 6nm and the total thickness of the first and second back surface field layers 321 and 322 is substantially 15nm.

In FIG. 9, the substrate 300 is made of crystalline silicon, and the emitter layers 310, 311 and 312 and the back surface field layers 320, 321 and 322 are made of the noncrystalline silicon.

Although solar cells have been described with reference to a number of illustrative implementations, it should be understood that numerous modifications and other implementations can be devised by those skilled in the art that will fall within the scope of the principles of this disclosure. More particularly, many variations and modifications are possible in the component parts and/or arrangements of the subject combination arrangement within the scope of the disclosure. For example, a location, number, and arrangement the emitter layers and the back surface field layers may be varied. In addition to variations and modifications in the component parts and/or arrangements, alternative uses will also be apparent to those skilled in the art.

## Claims

1. A solar cell comprising:
a crystalline substrate containing first impurities of a first conductive type;
a first non-crystalline layer containing second impurities of a second conductive type, the first non-crystalline layer having a first portion that includes a first concentration of the second impurities and a second portion that includes a second concentration of the second impurities, the second portion having a minimum distance from the crystalline substrate that is greater than a minimum distance of the first portion from the crystalline substrate, the second concentration being greater than the first concentration;
a first electrode; and
a second electrode electrically connected to the first non-crystalline layer and electrically isolated from the first electrode.

2. The solar cell of claim 1, further comprising a second non-crystalline layer containing third impurities of a third conductive type, the second non-crystalline layer having a first portion that includes a first concentration of the third impurities and a second portion that includes a second concentration of the third impurities, the second portion having a minimum distance from the crystalline substrate that is greater than a minimum distance of the first portion from the crystalline substrate, the second concentration being greater than the first concentration,
wherein the third conductive type is opposite of the second conductive type.

3. The solar cell of claim 2, wherein the second non-crystalline layer is positioned on a non-incident surface of the crystalline substrate upon which light is not incident.

4. The solar cell of claim 3, wherein the first non-crystalline layer is positioned on an incident surface of the crystalline substrate upon which light is incident.

5. The solar cell of claim 3, wherein the first non-crystalline layer is positioned on the non-incident surface of the crystalline substrate upon which light is not incident.

6. The solar cell of claim 1, wherein the first conductive type is the same as the third conductive type.

7. The solar cell of claim 1, wherein the first concentration of the second impurities of the first portion of the first non-crystalline layer is approximately zero.

8. The solar cell of claim 1, wherein a concentration of the second impurities increases at a predetermined rate between the first portion and the second portion.

9. The solar cell of claim 1, wherein the first portion of the first non-crystalline layer is an intrinsic semiconductor portion, and the second portion of the first non-crystalline layer is an extrinsic semiconductor portion.

10. The solar cell of claim 1, wherein the first portion of the first non-crystalline layer is positioned proximate the crystalline substrate, and the second portion of the first non-crystalline layer is positioned proximate a surface of the first non-crystalline layer opposite the crystalline substrate.

11. The solar cell of claim 1, wherein the first concentration and the second concentration of the second impurities are from approximately 0 cm⁻³ to approximately 1×10²³ cm⁻³.

12. A semiconductor structure positioned over a first surface of a crystalline semiconductor substrate of a solar cell, the crystalline semiconductor substrate being a first conductive type, the semiconductor layer comprising:
a first non-crystalline layer having a first concentration of impurities; and
a second non-crystalline layer having a second concentration of impurities, the second concentration being different than the first concentration,
wherein the first non-crystalline layer and the second non-crystalline layer are each non-intrinsic layers.

13. The semiconductor structure of claim 12, wherein the first non-crystalline layer has a minimum distance from the crystalline substrate that is greater than a minimum distance of the second non-crystalline layer from the crystalline substrate.

14. The semiconductor structure of claim 13, wherein the first concentration of impurities is greater than the second concentration of impurities.

15. The semiconductor structure of claim 13, wherein the second concentration of impurities is greater than the first concentration of impurities.
